# EUROPÄISCHE PATENTSCHRIFT

(11) **EP 1 450 135 B1**
(45) Veröffentlichungstag und Bekanntmachung des Hinweises auf die Patenterteilung: **13.08.2008**
(21) Anmeldenummer: 03027018.5
(22) Anmeldetag: 22.11.2003
(51) Int. Cl.: G01D 5/20, H05K 1/14

(54) **Induktiver Sensor und damit ausgestatteter Drehgeber**
Inductive sensor and rotary encoder using the same
Capteur inductif et capteur de rotation l'utilisant

(30) Priorität: 21.02.2003 DE 10307674
(43) Veröffentlichungstag der Anmeldung: 25.08.2004
(73) Patentinhaber: Dr. Johannes Heidenhain GmbH, 83292 Traunreut (DE)
(72) Erfinder: Rissing, Lutz, 83358 Seebruck (DE)

(56) Entgegenhaltungen:
- US-A- 5 740 527
- US-A1- 2001 053 068
- US-A1- 2002 011 839
- US-B1- 6 313 624

## Beschreibung

Die Erfindung betrifft einen induktiven Sensor zur Bestimmung von Relativpositionen, insbesondere von Relativwinkelpositionen gemäß dem Anspruch 1 und einen damit ausgestatteten Drehgeber gemäß dem Anspruch 9.

Induktive Sensoren werden beispielsweise in Drehgebern zur Bestimmung der Winkellage zweier relativ zueinander drehbaren Maschinenteile verwendet, aber auch bei Messgeräten zur Positionsbestimmung zweier relativ zueinander längsverschieblicher Maschinenteile.

Bei induktiven Sensoren werden häufig Erregerspulen und Empfängerspulen in Form von Leiterbahnen auf einer gemeinsamen Leiterplatte aufgebracht, die beispielsweise mit einem Stator eines Drehgebers fest verbunden ist. Dieser Leiterplatte gegenüber befindet sich eine weitere Platine, auf der in periodischen Abständen elektrisch leitende Flächen als Teilungsstruktur aufgebracht sind, und welche mit dem Rotor des Drehgebers drehfest verbunden ist. Wenn an den Erregerspulen ein elektrisches Erregerfeld angelegt wird, werden in den Empfängerspulen während der Relativdrehung zwischen Rotor und Stator von der Winkellage abhängige Signale erzeugt. Diese Signale werden dann in einer Auswerteelektronik weiterverarbeitet. Häufig sind die Bauelemente einer derartigen Auswerteelektronik auf einer weiteren Leiterplatte untergebracht. Die Leiterplatte mit den Erreger- und Empfängerspulen und die Leiterplatte mit der Auswerteelektronik sind nicht selten über Flex-Leiter und Steckverbindungen miteinander verbunden. Diese Art der elektrischen Verbindung nimmt ein relativ großes Volumen ein. Andererseits besteht aber permanent der Wunsch zur Miniaturisierung derartiger Sensoren bzw. Drehgebern.

In der DE 101 11 966 A1 wird ein Aufbau für einen induktiven Sensor beschrieben, bei dem die Erreger- und Empfängerspulen, sowie Bausteine der Auswerteelektronik in einer mehrschichtigen Struktur in Form eines Laminats ausgeführt ist. Dieser Aufbau hat jedoch den Nachteil, dass er gegenüber äußeren Einflüssen vergleichsweise empfindlich ist und keine optimale Raumausnutzung ermöglicht.

Aus dem Patent US 6313624 ist ein Sensor bekannt, welcher mehrere Leiterplatten umfasst und elektronische Bauteile aufweist. Derartig aufgebaute Sensoren haben jedoch den Nachteil, dass auch diese bei Einwirkung von äußeren Einflüssen relativ störungsanfällig sind.

Der Erfindung liegt daher die Aufgabe zugrunde, einen induktiven Sensor zu schaffen, welcher gegen äußere Einflüsse robust ist und einen überaus kleinen Bauraum erfordert. Ebenso wird durch die Erfindung ein zuverlässiger Drehgeber mit kleinen Außenabmessungen geschaffen.

Diese Aufgabe wird erfindungsgemäß durch die Merkmale des Anspruches 1 gelöst.

Erfindungsgemäß ist die Leiterplatte, auf der die Empfängerleiterbahnen aufgebracht sind und die Leiterplatte, auf der sich die Auswerteelektronik befindet, sandwichartig zusammengefügt, wobei empfindliche elektronische Bauteile der Auswerteelektronik zwischen diesen Leiterplatten untergebracht sind. Dabei weist zumindest eine der Leiterplatten einen teilweise oder vollständig umlaufenden Steg auf, so dass der Spalt zwischen den sandwichartig zusammengefügten Leiterplatten zumindest teilweise abgedeckt bzw. verschlossen wird.. Auf diese Weise sind die besagten elektronischen Bauteile durch die Leiterplatten vor äußeren Einflüssen geschützt.

Zum weiteren Schutz der Bauteile werden diese in einer bevorzugten Ausgestaltung der Erfindung in einer oder in mehreren Ausnehmungen der gegenüberliegenden Leiterplatte, also der Leiterplatte mit den Empfängerleiterbahnen, untergebracht.

Mit Vorteil ist ein Steg am Außenumfang, also mantelseitig, des Leiterplattenverbundes (aus den sandwichartig zusammengefügten Leiterplatten) vorgesehen.

Besonders günstig ist es, wenn der Hohlraum zwischen den sandwichartig zusammengefügten Leiterplatten, in welchem Bauteile der Auswerteelektronik untergebracht sind, mit einem Füllstoff vergossen ist. Durch diese Bauweise kann die Robustheit, insbesondere die Vibrationsfestigkeit, des induktiven Sensors und des damit ausgestatteten Drehgebers erhöht werden.

Vorteilhafte Ausbildungen der Erfindung entnimmt man den abhängigen Ansprüchen.

Weitere Einzelheiten und Vorteile des erfindungsgemäßen induktiven Sensors, sowie des damit ausgestatteten Drehgebers ergeben sich aus der nachfolgenden Beschreibung von Ausführungsbeispielen anhand der beiliegenden Figuren.

Es zeigen die
- Figur 1: eine perspektivische Ansicht der beiden Leiterplatten vor dem Zusammenfügen,
- Figur 2: einen Schnitt durch den erfindungsgemäßen induktiven Sensor,
- Figur 3: eine perspektivische Ansicht eines Drehgebers mit zur Veranschaulichung aufgebrochenem Gehäuse.

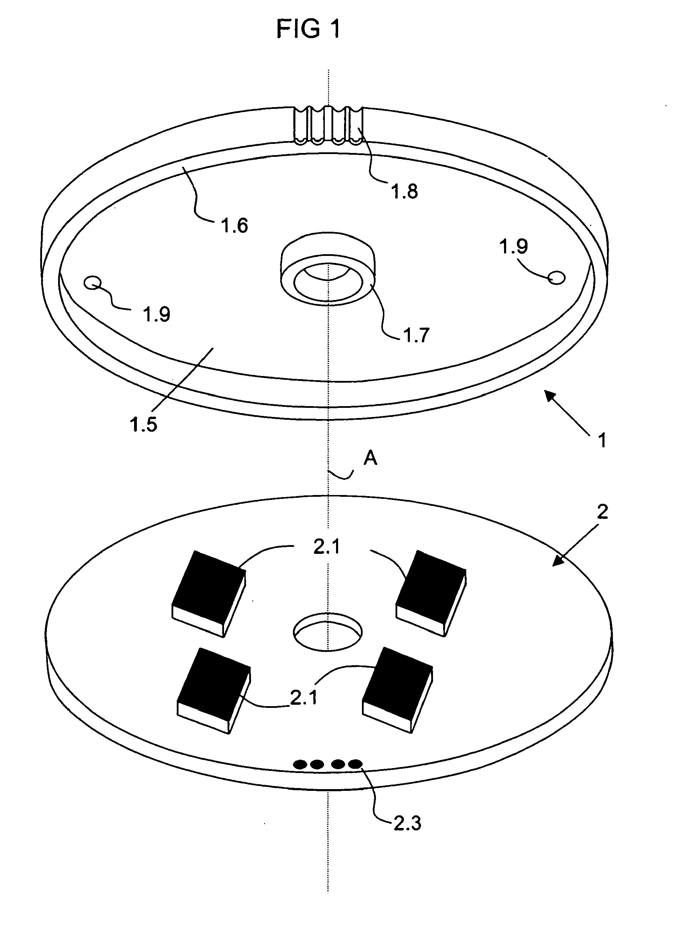

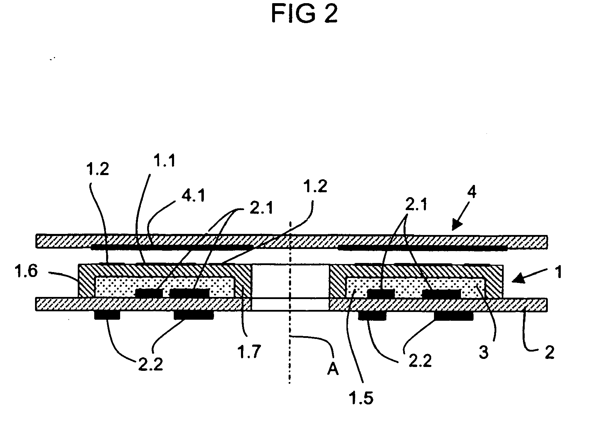

In der Figur 1 ist ein Teil eines induktiven Sensor in einer perspektivische Ansicht vor dem Zusammenfügen gezeigt. Der Sensor besteht unter anderem aus einer ringförmigen ersten Leiterplatte 1 auf Basis eines steifen glasfaserverstärkten Epoxydharzes, welche Empfängerleiterbahnen 1.1 und Erregerleiterbahnen 1.2 (siehe Figur 2) aufweist. Die erste Leiterplatte 1 hat eine ringförmige Ausnehmung 1.5, die aus dem Leiterplattenmaterial herausgefräst wurde, so dass als Begrenzung der Ausnehmung 1.5 zwei umlaufende Stege 1.6 und 1.7 vorliegen. Sowohl zum Herstellen eines elektrischen Kontaktes zwischen den Empfängerleiterbahnen 1.1 (und auch den Erregerspulen 1.2) mit der zweiten Leiterplatte 2 als auch zur mechanischen Verbindung der ersten Leiterplatte 1 mit der zweiten Leiterplatte 2 sind an der ersten Leiterplatte 1 sogenannte Halb-Hülsen 1.8 angeordnet, welche beim Zusammenbau des Sensors mit Lötpads 2.3 einer zweiten Leiterplatte 2 verlötet werden. Zum späteren Vergießen der zusammengefügten Leiterplatten 1, 2 sind Füllöffnungen 1.9 in Form von Bohrungen in der ersten Leiterplatte 1 vorgesehen.

Die zweite Leiterplatte 2, die ebenfalls als Substrat ein steifes glasfaserverstärktes Epoxydharz aufweist, ist an ihren beiden Oberflächen mit elektronischen Bauteile 2.1, 2.2 (siehe Figur 2) der Auswerteelektronik bestückt. Die der ersten Leiterplatte 1 zugewandte Oberfläche der zweiten Leiterplatte 2 weist besonders empfindliche Bauteile 2.1, im gezeigten Beispiel unter anderem ungehäuste ASICs auf, welche mit Hilfe der Chip on Board Technologie auf die Leiterplatte 1 aufgebracht wurden. Durch die Verwendung von ungehäusten Bauteilen 2.1 ist eine weitere Raumeinsparung möglich, weil der Platzbedarf für die Gehäuse nicht berücksichtigt werden muss.

In der Figur 2 ist eine Querschnittsdarstellung der Sensoranordnung gezeigt, wobei die beiden Leiterplatten 1, 2 bereits sandwichartig, also in paralleler Ausrichtung zueinander, zusammengefügt sind. Darin ist zu erkennen, dass die Ausnehmung 1.5 die besonders empfindlichen Bauteile 2.1 aufnimmt. Die erste Leiterplatte 1 wird quasi als Deckel zum Schutz der abgedeckten elektronischen Bauteile 2.1 verwendet. Dabei erfolgt die Abdeckung nicht nur in axialer Richtung, sondern auch in radialer Richtung, weil die Stege 1.6, 1.7 die Bauteile 2.1 auch in dieser Richtung schützen. Auf diese Weise sind die Bauteile 2.1 gegenüber äußeren Einflüssen, wie etwa gegen das Eindringen von Schmiermitteln oder Feuchtigkeit, sowie mechanischen Einflüssen wirksam abgeschirmt. Zur weiteren Steigerung des Schutzes gegen äußere Einflüsse, wird das Volumen zwischen der ersten Leiterplatte 1 und der zweiten Leiterplatte 2, also der durch die Ausnehmung gebildete Hohlraum mit einen Füllstoff 3 vergossen. Dabei wird der flüssige Füllstoff 3 durch eine der Füllöffnungen 1.9 in die Ausnehmung 1.5 gedrückt, während die verdrängte Luft durch die andere Füllöffnung 1.9 entweicht. Nach dem Vergießen härtet der zunächst flüssige Füllstoff 3 zu einer festen Masse aus. Alternativ dazu kann auch ein gelartiger Füllstoff 3, etwa auf Silikonbasis verwendet werden. Durch den eingebrachten Füllstoff 3 wird die Vibrationsfestigkeit des induktiven Sensors und damit die Robustheit des damit ausgestatteten Drehgebers erhöht.

Aus der Figur 2 ist unter anderem zu entnehmen, dass beide Flächen der zweiten Leiterplatte 2 für eine Bestückung mit Bauelementen 2.1, 2.2 zur Verfügung stehen. Das heißt, dass gegenüber einer einflächigen Bestückung bei gegebener Anzahl von Bauteilen 2.1, 2.2 eine Leiterplatte 2 mit reduziertem Durchmesser verwendet werden kann, was letztlich ausschlaggebend für die Außenabmessungen eines Drehgebers ist.

Neben der ersten Leiterplatte 1 und der zweiten Leiterplatte 2 ist in der Figur 2 darüber hinaus eine Platine 4 dargestellt, auf der eine Teilungsstruktur in Form von auf die Platine 4 periodisch aufgebrachten leitenden Flächen 4.1 angeordnet ist. Im Betrieb des Sensors dreht sich die Platine 4 gegenüber dem Sandwich-Verbund der beiden Leiterplatten 1, 2 um die Drehachse A.

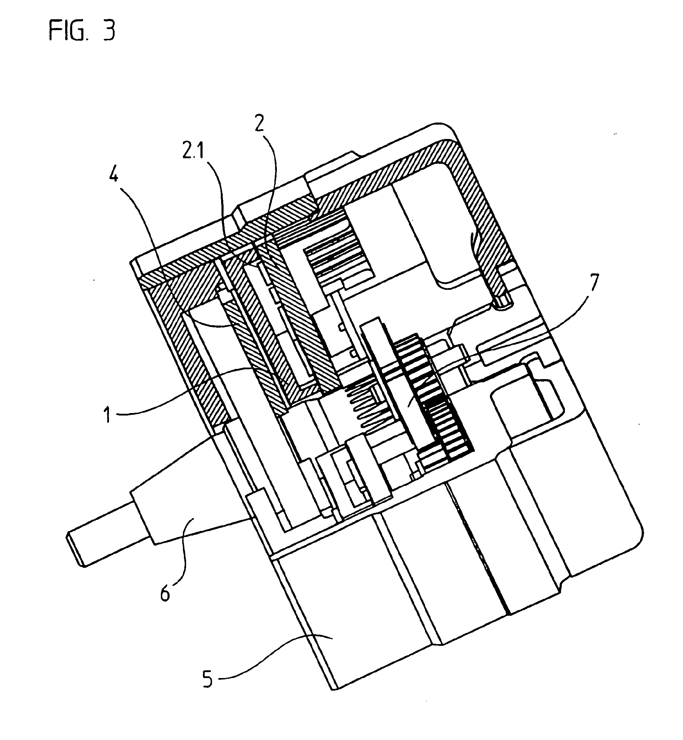

Die Figur 3 zeigt einen Drehgeber, der mit dem erfindungsgemäßen induktiven Sensor ausgestattet ist. Der Drehgeber weist ein feststehendes Gehäuse 5 und eine relativ zum Gehäuse drehbare Welle 6 auf. An der Welle 6 ist die Platine 4 mit der Teilungsstruktur 4.1 drehfest fixiert. Dagegen ist am Gehäuse 5 der sandwichartige Verbund, bestehend aus den beiden Leiterplatten 1, 2 befestigt. Darüber hinaus umfasst der Drehgeber ein Untersetzungsgetriebe 7, welches für eine Multi-Turn-Funktionalität des Drehgebers benötigt wird. Durch die kompakte Bauweise des induktiven Sensors kann nunmehr der Drehgeber signifikant verkleinert gebaut werden, darüber hinaus ist durch die hermetische Abdeckung der Bauteile 2.1 der Auswerteelektronik ein überaus zuverlässiger und robuster Drehgeber geschaffen worden.

## Patentansprüche

1. Induktiver Sensor, bestehend aus mindestens zwei Leiterplatten (1, 2), wobei
· auf der ersten Leiterplatte (1) Empfängerleiterbahnen (1.1) aufgebracht sind, und
· auf der zweiten Leiterplatte (2) Bauelemente (2.1) einer Auswerteelektronik zum Auswerten von Signalen angeordnet sind, welche von den Empfängerleiterbahnen (1.1) herrühren, wobei die beiden Leiterplatten (1, 2) sandwichartig zusammengefügt sind **dadurch gekennzeichnet, dass**
zumindest ein Bauelement (2.1) der Auswerteelektronik zwischen den beiden Leiterplatten (1, 2) untergebracht ist und zumindest eine der Leiterplatten (1, 2) einen zumindest teilweise umlaufenden Steg (1.6, 1.7) aufweist, so dass der Spalt zwischen den zusammengefügten Leiterplatten (1, 2) zumindest teilweise abgedeckt ist.

2. Induktiver Sensor gemäß dem Anspruch 1, wobei die zweite Leiterplatte (2) beidseitig mit Bauelementen (2.1) der Auswerteelektronik bestückt ist.

3. Induktiver Sensor gemäß dem Anspruch 1, wobei die erste Leiterplatte (1) eine Ausnehmung (1.5) aufweist zur Aufnahme von zumindest einem Bauteil (2.1) der Auswerteelektronik.

4. lnduktiver Sensor gemäß dem Anspruch 1, wobei zumindest eine der Leiterplatten (1, 2) an deren Mantelseite den zumindest teilweise umlaufenden Steg (1.6, 1.7) aufweist.

5. Induktiver Sensor gemäß dem Anspruch 1, wobei die beiden Leiterplatten (1, 2) durch eine Lötverbindung miteinander elektrisch und/oder mechanisch verbunden sind.

6. Induktiver Sensor gemäß dem Anspruch 1, wobei die beiden Leiterplatten (1, 2) durch eine Klebeverbindung miteinander verbunden sind.

7. Induktiver Sensor gemäß dem Anspruch 1, wobei die beiden Leiterplatten (1, 2) durch eine Schweißverbindung miteinander verbunden sind.

8. Induktiver Sensor gemäß dem Anspruch 1, wobei das Volumen zwischen den beiden Leiterplatten (1, 2) mit einem Füllstoff (3) ausgefüllt ist.

9. Drehgeber mit einem induktiven Sensor gemäß dem Anspruch 1.

## Claims

1. An inductive sensor, consisting of at least two printed circuit boards (1, 2), wherein
receiver conductor tracks (1.1) are applied to the first printed circuit board (1), and components (2.1) of an evaluation electronics system for the evaluation of signals are arranged on the second printed circuit board (2), which signals emanate from the receiver conductor tracks (1.1), wherein
the two printed circuit boards (1, 2) are joined together in the form of a sandwich,
**characterised in that** at least one component (2.1) of the evaluation electronics system is accommodated between the two printed circuit boards (1, 2) and at least one of the printed circuit boards (1, 2) has a web (1.6, 1.7) at least partially surrounding the printed circuit board, so that the gap between the printed circuit boards (1, 2) that are joined together is at least partially covered.

2. The inductive sensor according to Claim 1, wherein
the second printed circuit board (2) is fitted on both sides with components (2.1) of the evaluation electronics system.

3. The inductive sensor according to Claim 1, wherein
the first printed circuit board (1) has a recess (1.5) for the accommodation of at least one component (2.1) of the evaluation electronics system.

4. The inductive sensor according to Claim 1, wherein
at least one of the printed circuit boards (1, 2) on its casing side has the web (1.6, 1.7) at least partially surrounding the printed circuit board.

5. The inductive sensor according to Claim 1, wherein
the two printed circuit boards (1, 2) are connected together electrically and/or mechanically by means of a soldered joint.

6. The inductive sensor according to Claim 1, wherein
the two printed circuit boards (1, 2) are connected together by means of an adhesively bonded joint.

7. The inductive sensor according to Claim 1, wherein
the two printed circuit boards (1, 2) are connected together by means of a welded joint.

8. The inductive sensor according to Claim 1, wherein
the volume between the two printed circuit boards (1, 2) is filled with a filler material (3).

9. A rotary transducer with an inductive sensor according to Claim 1.

## Revendications

1. Détecteur inductif, constitué de deux cartes de circuit imprimé (1, 2), dans lequel
- des conducteurs imprimés récepteur (1.1) sont appliqués sur la première carte de circuit imprimée (1), et
- des éléments de construction (2.1) d'une électronique d'évaluation sont disposés sur la deuxième carte de circuit imprimé (2), pour l'évaluation de signaux générés par les conducteurs imprimés récepteurs (1.1), les deux cartes de circuit imprimé (1, 2) étant assemblées entre elles à la façon d'un sandwich, **caractérisé en ce que**
au moins un élément de construction (2.1) de l'électronique d'évaluation est intercalé entre les deux cartes de circuit imprimé (1, 2), et au moins une des deux cartes de circuit imprimé (1, 2) comporte une âme (1.6, 1.7) au moins partiellement périphérique, si bien que la fente entre les cartes de circuit imprimé (1, 2) est au moins partiellement recouverte.

2. Détecteur inductif selon la revendication 1, dans lequel la deuxième carte de circuit imprimé (2) est équipée des deux côtés avec des éléments de construction (2.1) de l'électronique d'évaluation.

3. Détecteur inductif selon la revendication 1, dans lequel la première carte de circuit imprimé (1) comporte un évidement (1.5) pour la réception d'au moins un élément de construction (2.1) de l'électronique d'évaluation.

4. Détecteur inductif selon la revendication 1, dans lequel au moins des cartes de circuit (1, 2) comporte, sur sa face extérieure, l'âme (1.6, 1.7) au moins partiellement périphérique.

5. Détecteur inductif selon la revendication 1, dans lequel les deux cartes de circuit imprimé (1, 2) sont reliées entre elles électriquement et/ou mécaniquement par une connexion soudée.

6. Détecteur inductif selon la revendication 1, dans lequel les deux cartes de circuit imprimé (1, 2) sont reliées entre elles par un assemblage collé.

7. Détecteur inductif selon la revendication 1, dans lequel les deux cartes de circuit imprimé (1, 2) sont reliées entre elles par un assemblage soudé.

8. Détecteur inductif selon la revendication 1, dans lequel le volume entre les deux cartes de circuit imprimé (1, 2) est rempli d'un agent de charge (3).

9. Capteur de rotation avec un détecteur inductif selon la revendication 1.
